Europäisches Patentamt

European Patent Office

Office européen des brevets

(11) Veröffentlichungsnummer: **0 149 023**
**A1**

(19)

(12) **EUROPÄISCHE PATENTANMELDUNG**

(21) Anmeldenummer: **84112509.9**

(22) Anmeldetag: **17.10.84**

(51) Int. Cl.⁴: **H 03 F 3/68**
**H 04 R 5/04**

(30) Priorität: **17.11.83 DE 3341570**

(43) Veröffentlichungstag der Anmeldung:
**24.07.85 Patentblatt 85/30**

(84) Benannte Vertragsstaaten:
**AT CH DE FR IT LI**

(71) Anmelder: **GRUNDIG E.M.V. Elektro-Mechanische Versuchsanstalt Max Grundig holländ. Stiftung & Co. KG.**
**Kurgartenstrasse 37**
**D-8510 Fürth(DE)**

(72) Erfinder: **Fischelmayer, Heinrich**
**Siebenbürgener Strasse 13**
**D-8502 Zirndorf(DE)**

(72) Erfinder: **Sinning, Hans**
**Taubenweg 24**
**D-8510 Fürth(DE)**

(74) Vertreter: **Kolb, Max**
**Kurgartenstrasse 37**
**D-8510 Fuerth/Bayern(DE)**

(54) **Endstufenanordnung.**

(57) Bei einer Endstufenanordnung zur Erzeugung von zwei zueinander gegenphasigen Ausgangssignalen sind einem zwischen den Ausgängen zweier Leistungsverstärker liegenden Lastanschluß (13) zwei weitere, gleichstrommäßig in Reihe liegende Lastanschlüsse (14, 15) gleich- oder wechselstrommäßig parallelgeschaltet. Der Verbindungspunkt (17) der in Reihe liegenden Lastanschlüsse ist wechselstrommäßig bzw. gleichstrommäßig an Masse gelegt. Je nach Belegung der Lastanschlüsse sind die Leistungsverstärker wahlweise als Brückenendstufe oder zwei Einfach-Endstufen betreibbar. Dabei kann automatisch ein Stellglied (5) (Fader) zur Dämpfungs- oder Überblendregelung im Einfach-Betrieb wirksam und im Brückenbetrieb unwirksam geschaltet (4) werden.

EP 0 149 023 A1

Croydon Printing Company Ltd.

FIG.1

# E N D S T U F E N A N O R D N U N G

## BESCHREIBUNG

Die Erfindung betrifft eine Endstufenanordnung der im Oberbegriff des Anspruchs 1 angegebenen Art.

Es ist bekannt, Leistungsverstärker mit mindestens zwei Verstärkerschaltungen in verschiedenen Betriebsmoden oder Schaltungskonfigurationen zu realisieren. Bei einer bekannten Anordnung ist hierzu ein Schalternetzwerk vorgesehen, mittels welchem die Spannungsverstärkerstufen und die Leistungsverstärkerstufen wahlweise miteinander verbindbar sind, so daß unterschiedliche Betriebsmoden, insbesondere Parallelbetrieb, Zweikanalbetrieb und Brückenbetrieb, entstehen (DE-AS 23 47 733).

Der Nachteil der bekannten Verstärkeranordnung liegt darin, daß der wahlweise Betrieb der aus mindestens zwei Verstärkerschaltungen bestehenden Anordnung in verschiedenen Betriebsmoden den Einsatz sehr aufwendiger Schalternetzwerke erfordert.

Der Erfindung liegt die Aufgabe zugrunde, eine Endstufenanordnung der im Oberbegriff des Anspruchs 1 angegebenen Art durch einfache schaltungstechnische Maßnahmen so auszubilden, daß sie ohne Eingriff in die Schaltung und ohne den Einsatz aufwendiger Schalternetzwerke wahlweise als Verstärker mit zwei getrennten Einfach-Endstufen oder als Verstärker mit einer Brückenendstufe betrieben werden kann.

Diese Aufgabe wird durch die im kennzeichnenden Teil des Anspruches 1 angegebenen Merkmale gelöst. Vorteilhafte Weiterbildungen der Erfindung sind in den Unteransprüchen gekennzeichnet.

Bei der erfindungsgemäßen Endstufenanordnung erfolgt die Wahl der gewünschten Betriebsart (Einfach- oder Brückenbetrieb) durch eine entsprechende Belegung der mit den Ausgängen der Endstufen verbundenen Lastanschlußbuchsen. In vorteilhafter Weise wird ein in der Verstärkeranordnung vorhandener Fader zur Dämpfungs- oder

Überblendregelung beim Betrieb der Anordnung als Verstärker mit zwei getrennten Einfach-Endstufen wirksam zwischen die beiden Verstärkerzweige geschaltet. Für den Fall, daß der Verstärker durch entsprechende Belegung der Lastanschlußbuchsen in Brückenschaltung betrieben wird, bleibt der Fader automatisch abgeschaltet. Durch diese Schaltungsmaßnahme ist sichergestellt, daß bei Brückenbetrieb unabhängig von der Einstellung des Faders beide Endstufen amplitudenmäßig gleich große Ansteuerungssignale erhalten.

Die erfindungsgemäße Endstufenanordnung eignet sich in vorteilhafter Weise sowohl für Anwendungen im Audiobereich, insbesondere zum wahlweisen Betrieb der Anordnung als Brückenverstärker mit hoher Ausgangsleistung oder als Verstärker mit getrennten Einfach-Endstufen kleinerer Ausgangsleistung und Überblendregelung, als auch für Anwendungen im Videobereich. Dort liegt der Vorteil der Endstufenanordnung in der wahlweisen Speisung einer Last über symmetrische Verbindungen oder zweier Lasten über asymmetrische Verbindungen (Koaxialleitungen) unterschiedlicher Dämpfung.

Ein Ausführungsbeispiel der Erfindung ist im folgenden anhand von Zeichnungen näher erläutert. Es zeigen:

Fig. 1   eine Prinzipschaltung der erfindungsgemäßen Endstufenanordnung

Fig. 2 eine erste Ausführungsform möglicher
Lastanschlußbuchsen

Fig. 3 eine zweite Ausführungsform möglicher
Lastanschlußbuchsen

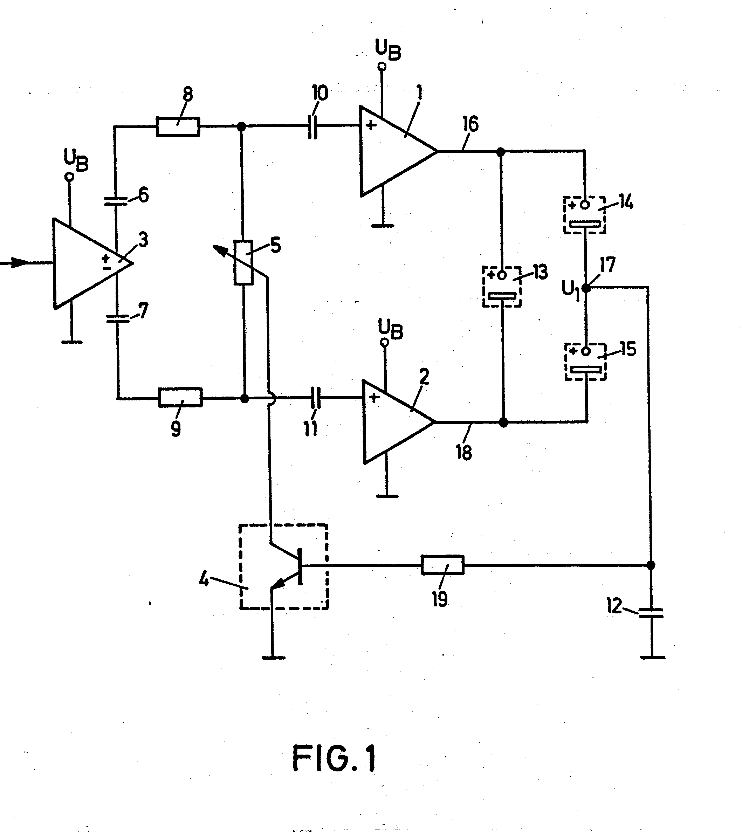

Die Verstärkeranordnung gemäß Fig. 1 zeigt zwei voneinander getrennte Leistungsendstufen 1 und 2. Der nichtinvertierende Eingang jeder Endstufe ist jeweils über einen Koppelkondensator 10, 11 mit einem Vorwiderstand 8, 9 für einen Fader 5 sowie mit jeweils einem der beiden Außenanschlüsse des Faders 5 verbunden. Der Vorwiderstand 8 ist über einen Koppelkondensator 6 an den nichtinversen Ausgang und der Vorwiderstand 9 über einen weiteren Koppelkondensator 7 an den inversen Ausgang einer Phasenumkehrstufe 3 angeschlossen. Am Ausgang 16 der Leistungsendstufe 1 liegen die jeweils positiven Pole zweier Lastanschlußbuchsen 13 und 14. Der negative Pol der Lastanschlußbuchse 13 und der negative Pol einer weiteren Lastanschlußbuchse 15 sind mit dem Ausgang 18 der Leistungsendstufe 2 verbunden. An den Verbindungspunkt 17 des negativen Pols der Lastanschlußbuchse 14 mit dem positiven Pol der Lastanschlußbuchse 15 sind ein zur Basis eines Transistorschalters 4 führender Vorwiderstand 19 sowie ein auf Masse liegender Kondensator 12 angeschlossen. Während der Emitter des Transistorschalters 4 ebenfalls gegen Masse geschaltet ist, steht der Kollektor desselben Schalters mit dem variablen Abgriff des Potentiometers 5 (Fader) in Verbindung. Bei einer weiteren Ausführung der Erfindung kann der Transistorschalter 4 auch durch einen elektromechanischen Schalter ersetzt werden.

Mit einer derartigen Schaltungsanordnung ist es möglich, die Endstufen 1, 2 durch entsprechende Belegung der Lastanschlußbuchsen 13, 14, 15 wahlweise in Brückenschaltung oder als zwei getrennte Einfach-Endstufen zu betreiben. Durch die Wahl der Betriebsart erfolgt gleichzeitig die automatische Ab- bzw. Anschaltung des Faders.

Beim Anschluß einer Last an die Buchse 13 arbeitet die Anordnung als Brückenverstärker mit symmetrischem Ausgang. Da in diesem Betriebszustand die Lastanschlußbuchsen 14 und 15 nicht belegt sind, erhält die Basis des Transistorschalters 4 keine Steuerspannung über den Vorwiderstand 19 ($U_1 = 0$), so daß die Kollektor-Emitter-Strecke des Transistors gesperrt, der Schalter also geöffnet bleibt. Die damit gekoppelte Trennung des Abgriffs des Faders 5 von Masse bewirkt, daß der Fader 5 unwirksam bleibt und demzufolge beide Endstufen unabhängig von der Einstellung des Faders amplitudenmäßig gleich große Eingangssignale erhalten.

Werden dagegen die Anschlußbuchsen 14 und 15 jeweils durch eine Last mit Gleichstromweg abgeschlossen (Buchse 13 offen), so steht am Verbindungspunkt 17 der beiden Lasten eine Gleichspannung $U_1$ zur Verfügung, die der an den Ausgängen 16 und 18 der beiden Endstufen 1 und 2 anliegenden Gleichspannung entspricht. Im allgemeinen stimmt die an den Ausgängen der Endstufen vorhandene Gleichspannung mit der halben an den Endstufen anliegenden Betriebsspannung $U_B$ überein. Der am Punkt 17 angeschlossene Kondensator 12 hat nun bei der vorliegenden Betriebsart mehrere Funktionen. Zum einen erfolgt über ihn die wechselstrommäßige Aussteuerung der beiden Lasten gegen Masse, so daß die Anordnung als Verstärker mit zwei getrennten Einfach-Endstufen arbeitet. Zum anderen glättet er die am Punkt 17 abgegriffene und zur Steuerung der Transistorstufe 4 verwendete Gleichspannung. Die somit an der Basis des Transistorschalters 4 anliegende Spannung bewirkt, daß die Kollektor-Emitter-Strecke des Transistors leitend und demzufolge der Abgriff des Faders 5 gegen Masse geschaltet wird. Dadurch wird der Fader in Funktion gesetzt und erlaubt eine Überblend- oder Dämpfungseinstellung der beiden Verstärkerzweige. Die an den Ausgängen 16 und 18 der beiden Endstufen vorhandene Phasendifferenz von $180^o$ zwischen den dort anliegenden Ausgangssignalen wird durch die unterschiedliche Polung der an die Buchsen 14 und 15 angeschlossenen Lasten kompensiert.

Bei einer weiteren Ausführungsform der Erfindung ist es auch möglich, den Verbindungspunkt 17 der Lastanschlüsse 14, 15 direkt an Masse zu schalten und die verbleibenden Kontakte der Lastanschlüsse 14, 15 über Kondensatoren mit den jeweiligen Verbindungspunkten der Leistungsverstärkerausgänge 16, 18 und des Lastanschlusses 13 zu verbinden. Allerdings erfolgt bei dieser Ausführung keine automatische An- oder Abschaltung des Faders 5.

Prinzipiell können die Ausgänge 13, 14 und 15 als drei getrennte Buchsen ausgeführt werden. Wegen der günstigen Schaltungsanordnung bieten sich jedoch für bestimmte Anwendungen bei entsprechender Ausführung von Steckverbindungen vorteilhafte Zusammenfassungsmöglichkeiten an.

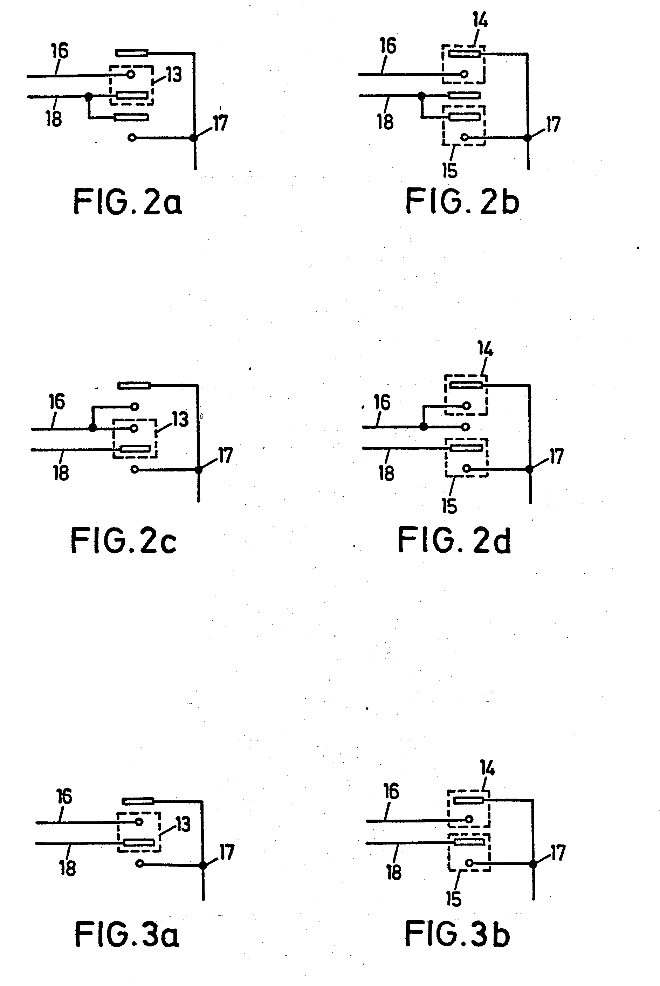

Die Figuren 2a bis d zeigen eine erste Ausführungsform für eine Anordnung der Lastanschlußbuchsen, bei der zum Beispiel im Audiobereich herkömmliche Lautsprecherstecker verwendet werden können. Hierbei werden die Steckkontakte für die Lastanschlüsse 13, 14 und 15 so untereinander angeordnet, daß entweder die am Ausgang 16 der Endstufe 1 angeschlossenen positiven Kontakte der Lastanschlüsse 13 und 14 oder die am Ausgang 18 der Endstufe 2 angeschlossenen negativen Kontakte der Lastanschlüsse 13 und 15 zu einem einzigen Kontakt zusammengefaßt werden können. Die Fig. 2a beziehungsweise 2c zeigt die Belegung dieser Kombinationsbuchse
bei Brückenbetrieb; die Fig. 2b bzw. 2d zeigt entsprechend die Belegung für Einfachbetrieb. Man erkennt, daß der Anschlußstecker der Last für Brückenbetrieb im Vergleich zu den Anschlußsteckern der
Lasten für Einfachbetrieb um 180° gedreht eingesteckt
werden muß.

Die Figuren 3a und 3b zeigen eine weiter vereinfachte
Ausführung der in Fig. 2 dargestellten Anordnung von
möglichen Lastanschlußbuchsen. Hierbei werden sowohl
die am Ausgang 16 der Endstufe 1 angeschlossenen positiven
Kontakte der Lastanschlüsse 13 und 14 als auch die am
Ausgang 18 der Endstufe 2 angeschlossenen negativen
Kontakte der Lastanschlüsse 13 und 15 jeweils zu einem
einzigen Kontakt zusammengefaßt. Die Fig. 3a bzw. 3b gibt
die Belegung dieser Kombinationsbuchse für Brücken- bzw.
Einfachbetrieb wieder. Auch hier ist erkennbar, daß der
Anschlußstecker der Last für Brückenbetrieb im Vergleich zu den Anschlußsteckern der Lasten für Einfachbetrieb um 180° gedreht eingesteckt werden muß.

—1—

# ENDSTUFENANORDNUNG

## PATENTANSPRÜCHE

1. Endstufenanordnung zur Erzeugung von zwei zueinander gegenphasigen Ausgangssignalen mit einer Vorstufe, die entweder gleichphasige Steuersignale an einen invertierenden und einen nichtinvertierenden Leistungsverstärker oder gegenphasige Steuersignale an zwei nichtinvertierende oder an zwei invertierende Leistungsverstärker liefert, d a d u r c h  g e - k e n n z e i c h n e t , daß einem zwischen den Ausgängen der Leistungsverstärker (1, 2) liegenden Lastanschluß (13) zwei weitere, gleichstrommäßig in Reihe liegende Lastanschlüsse (14, 15) gleich- oder wechselstrommäßig parallelgeschaltet sind, daß der Verbindungspunkt (17) dieser Lastanschlüsse (14, 15)

- 2 -

wechselstrommäßig bzw. gleichstrommäßig an Masse gelegt ist, und daß die Leistungsverstärker je nach Belegung der Lastanschlüsse (13, 14, 15) wahlweise als Brückenendstufe oder zwei Einfach-Endstufen betreibbar sind.

2. Anordnung nach Anspruch 1, d a d u r c h g e k e n n z e i c h n e t , daß der Verbindungspunkt (17) der Lastanschlüsse (14, 15) an Masse geschaltet ist und daß die Lastanschlüsse (14, 15) mit den jeweiligen Verbindungspunkten der Leistungsverstärkerausgänge (16, 18) und des Lastanschlusses (13) über Kondensatoren verbunden sind.

3. Anordnung nach Anspruch 1, d a d u r c h g e k e n n z e i c h n e t , daß der Verbindungspunkt (17) der Lastanschlüsse (14, 15) über einen Kondensator (12) an Masse geschaltet ist und daß die Lastanschlüsse (14, 15) mit den jeweiligen Verbindungspunkten der Leistungsverstärkerausgänge (16, 18) und des Lastanschlusses (13) gleichstrommäßig verbunden sind.

4. Anordnung nach Anspruch 3, d a d u r c h g e k e n n z e i c h n e t , daß der Verbindungspunkt (17) der Lastanschlüsse (14, 15) über einen Vorwiderstand (19) an den Steuereingang eines elektrisch steuerbaren Schalters (4) geschaltet ist, der je nach Belegung der Lastanschlüsse (13, 14, 15) automatisch ein Stellglied (Fader) zur Dämpfungs- oder Überblendregelung im Einfach-Betrieb wirksam und im Brückenbetrieb unwirksam schaltet.

5. Anordnung nach Anspruch 4, d a d u r c h g e k e n n z e i c h n e t , daß die beiden Leistungsverstärker (1, 2) eingangsseitig mit einem als Stellglied wirkenden Potentiometer (5) verbunden sind, dessen Abgriff je nach Belegung der Lastanschlüsse (13, 14, 15) über den Schalter (4) an Masse gelegt oder von Masse getrennt wird.

6. Anordnung nach Anspruch 4, d a d u r c h g e k e n n z e i c h n e t , daß die Eingänge der beiden Leistungsverstärker (1, 2) mit der Vorstufe (3), die wahlweise eine Trenn- oder Phasenumkehrstufe enthalten kann, über ein an sich bekanntes Koppelnetzwerk (6, 7, 8, 9, 10, 11) verbunden sind.

7. Anordnung nach einem oder mehreren der Ansprüche 1 bis 6, d a d u r c h g e k e n n z e i c h n e t , daß die Lastanschlüsse (13, 14, 15) in einer kombinierten Anschlußbuchse angeordnet sind.

8. Anordnung nach Anspruch 7, d a d u r c h g e k e n n z e i c h n e t , daß die an einem Ausgang (16 oder 18) der Leistungsverstärker (1 oder 2) angeschlossenen Kontakte der Lastanschlüsse (13, 14 oder 13, 15) zu einem einzigen Kontakt der kombinierten Anschlußbuchse zusammengefaßt sind.

9. Anordnung nach Anspruch 7, d a d u r c h g e k e n n z e i c h n e t , daß sowohl die am Ausgang (16) des Leistungsverstärkers (1) angeschlossenen Kontakte der Lastanschlüsse (13, 14) als auch die am Ausgang (18) des anderen Leistungsverstärkers (2) angeschlossenen Kontakte der Lastanschlüsse (13, 15) jeweils zu einem einzigen Kontakt der kombinierten Anschlußbuchse zusammengefaßt sind.

10. Anordnung nach Anspruch 9, d a d u r c h g e k e n n z e i c h n e t , daß automatisch bei Belegung des Lastanschlusses (13) für Brückenbetrieb die Lastanschlüsse (14, 15) für Einfachbetrieb blockiert sind und daß bei Belegung bereits einer der Lastanschlüsse (14, 15) für Einfachbetrieb der Lastanschluß (13) für Brückenbetrieb blockiert ist.

1/2

FIG.1

Reg. 1928
0149023

FIG. 2a

FIG. 2b

FIG. 2c

FIG. 2d

FIG. 3a

FIG. 3b

Europäisches
Patentamt

**EUROPÄISCHER RECHERCHENBERICHT**

**0149023**
Nummer der Anmeldung

EP 84 11 2509

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl ³) |
|---|---|---|---|
| A,D | DE-B-2 347 733 (SONY) <br> * Figur 1; Spalte 10, Tabelle * | 1 | H 03 F 3/68 <br> H 04 R 5/04 |
| P,A | US-A-4 433 209 (N. KUROSAWA et al.) <br> * Figur 3; Spalte 4, Zeile 53 - Spalte 5, Zeile 24 * | 1,4 | |
| A | FUNKSCHAU, Nr. 15, Juli 1978 I. PORGES "Hi-Fi-Receiver mit Brückenschaltung der Endstufen", Seiten 730-732 <br> * Seite 731, Bild 2, Referenz Nr. R2 * | 5 | |
| A | DE-A-2 436 724 (SONY) <br><br> * Figur 1; Seite 5, Zeile 26 - Seite 6, Zeile 16 * | | **RECHERCHIERTE SACHGEBIETE (Int. Cl ³)** |
| A | FR-A-2 440 646 (BLAUPUNKT) <br><br> * Figur 1 * | | H 03 F 3/20 <br> H 03 F 3/68 <br> H 04 R 5/04 |

Der vorliegende Recherchenbericht wurde für alle Patentansprüche erstellt.

| Recherchenort <br> BERLIN | Abschlußdatum der Recherche <br> 14-02-1985 | Prüfer <br> BREUSING J |
|---|---|---|